# EUROPEAN PATENT APPLICATION

(11) **EP 1 575 095 A1**
(43) Date of publication of application: **14.09.2005**
(21) Application number: 03780780.7
(22) Date of filing: 16.12.2003
(51) Int. Cl.: H01L 29/737

(54) **SEMICONDUCTOR MATERIAL HAVING BIPOLAR TRANSISTOR STRUCTURE AND SEMICONDUCTOR DEVICE USING SAME**

(30) Priority: 17.12.2002 JP 2002364547
(71) Applicant: Sumitomo Chemical Company, Limited, Tokyo 104-8260 (JP)
(72) Inventor: INOUE, Akira, Abiko-shi, Chiba 270-1152 (JP); HATA, Masahiko, Tsuchiura-shi, Ibaraki 300-0845 (JP); KURITA, Yasuyuki, Tsukuba-shi, Ibaraki 305-0045 (JP)
(74) Representative: Duckett, Anthony Joseph
(86) International application number: PCT/JP2003/016082
(87) International publication number: WO 2004/055903

(57) **Abstract**

In an epitaxial substrate (20) comprising a collector layer (22), a base layer (23) and an emitter layer (24) formed on a semi-insulating GaAs substrate (21), a hole barrier layer (22C) is provided in the collector layer (22) to prevent influx of holes from the base layer (23), whereby the flow of collector current is suppressed when the collector current density rises and electron velocity is saturated, suppressing thermal runaway of the collector current without a ballast resistance or the like. Also, thermal runaway of the collector current is suppressed by providing an additional layer (2C) for generating, in the conduction band, an electron barrier by means of electrons accumulated in the collector layer (2) when the collector current density rises.

## Description

### TECHNICAL FIELD

The present invention relates to a semiconductor material having a bipolar transistor structure that can suppress thermal runaway caused by operating current, and a semiconductor device using same.

### BACKGROUND ART

Generally, in semiconductor devices there is a tendency for thermal runaway to be produced that is caused by the synergistic action of increased loss of electric power generated in the semiconductor device, and the free electrons generated by thermal excitation therefrom. For example, when a large collector current flows in a bipolar transistor used for amplifying electric power or the like, the transistor heats up due to the large operating current of the transistor. As a result, there is a positive feedback action as it becomes easier for current to flow, leading to more current flowing, and hence more heating up, leading to the occurrence of so-called thermal runaway and burning when the current flowing in the transistor is at or over the permissible value.

In actual transistor devices, collector current becomes concentrated in one part in the device due to device non-uniformity, and owing to the device resistance, the portion in which this concentration arises heats up, causing partial thermal runaway. Consequently, even though the overall amount of device current may not exceed the kind of low level that prevents thermal runaway occurring, the concentration of current in one part of the device can produce a localized portion of increased current density in the device, giving rise to thermal runaway in that portion, thereby resulting in the breakdown of the whole device. This can be prevented by making devices in which the current flows uniformly so that current concentration does not occur. However, there are severe requirements with respect to process steps and substrate manufacturing steps, making the manufacture of such a device unrealistic from the aspect of both cost and technology.

Conventional measures against thermal runaway that are employed include a method of limiting the amount of current by connecting emitter resistors (ballast resistors) in series, and a method in which a high resistance layer (ballast layer) is inserted into the emitter layer when semiconductor thin films for the transistor are being manufactured.

However, there are problems with using such methods that obtain stable device operation by utilizing a negative feedback effect derived from adding a resistance to the emitter, such as that the series-connected resistance decreases high-frequency gain, and that at low current operation, it functions as a simple resistor, degrading device characteristics. In addition to these problems, the former method, in which an external ballast resistance is attached, gives rise to problems such as that throughput is reduced by the increase in device size and the increase in device process steps.

An object of the present invention is to provide a semiconductor material having a bipolar transistor structure and a semiconductor device using same that can resolve the above problems of the prior art.

Another object of the present invention is to provide a semiconductor material having a bipolar transistor structure that imparts an effect for suppressing thermal runaway, and a semiconductor device using same.

Another object of the present invention is to provide a semiconductor material having a bipolar transistor structure characterized by exhibiting a function of controlling thermal runaway by producing an electron barrier in the collector layer when the collector current reaches a density that immediately precedes the start of thermal runaway by the transistor, and a semiconductor device using same.

Another object of the present invention is to provide a semiconductor material having a bipolar transistor structure that can suppress the problem of bipolar transistor thermal runaway without employing a ballast resistance or ballast layer or the like, and a semiconductor device using same.

### DISCLOSURE OF THE INVENTION

To resolve the above problems, the present invention was accomplished to enable a bipolar transistor to be realized that controls characteristic change from heat generated by current during operation of the bipolar transistor and has stable performance with respect to temperature change, without employing an external element such as a ballast resistance, by employing a band structure in the bipolar transistor collector layer that can effectively utilize the base pushout effect and obstruct the electron movement that causes thermal runaway.

That is, the present invention utilizes a phenomenon, that is, the base pushout effect, in which electrons that are collected in the collector portion in the vicinity of the base-collector interface owing to electron velocity saturation caused by high collector current density elevate the conduction band on the collector base side of the interface, forming an electron barrier, while at the same time the valence band is also elevated and holes flow in from the base, and the holes that flow in bring down the band until it settles at the same height as the base. Explained more specifically, it limits the collector current that causes thermal runaway by controlling the location of band elevation due to the accumulated electrons, and, further, by maintaining the elevation after until the collector current falls after the band is elevated.

In a semiconductor material comprising a bipolar transistor structure having a collector layer, a base layer and an emitter layer, a characterizing feature of the present invention is the provision of an additional layer in the collector layer for producing an electron barrier in the conduction band from electrons accumulated in the collector layer when the collector current density increases. The additional layer can be an InGaAs layer or a layer doped with a p-type dopant at up to 1 x 10¹⁸cm⁻². A hole barrier layer may be provided between the additional layer and the base layer to prevent diffusion of holes.

In a semiconductor material comprising a bipolar transistor structure having a collector layer, a base layer and an emitter layer, another characterizing feature of the present invention is the provision of a hole barrier layer for preventing diffusion of holes having the effect of lowering the elevation of the band by electrons accumulated in the collector layer when the collector current density increases, maintaining band elevation. A configuration may be used in which a layer doped with a p-type dopant is provided between the hole barrier layer and the base layer. Here, the semiconductor material of the collector layer fabricated using a chemical compound semiconductor substrate may be GaAs or InGaAs, and the material of the hole barrier layer may be any from among InGaP, InGaAsP, InGaAs, p⁺ -GaAs, GaAs and p⁺ -InGaAs. The hole barrier layer material may be the semiconductor material InGaP having an In composition of not less than 0.6.

By using the above semiconductor material to manufacture various semiconductor devices, semiconductor devices can be obtained having a thermal runaway suppression effect.

### BRIEF DESCRIPTION OF DRAWINGS

Figure 1 is a diagram showing the layer structure of an embodiment of the present invention.
Figure 2 is a diagram for explaining the electron barrier formed in the collector layer of the epitaxial substrate of Figure 1.
Figure 3 is a diagram showing the layer structure of another embodiment of the present invention.
Figure 4 is a diagram showing the layer structure of another embodiment of the present invention.
Figure 5 is a graph showing characteristics of embodiments of the present invention.
Figure 6 is a graph showing characteristics of another embodiment of the present invention.
Figure 7 is a graph for explaining the thermal runaway suppression effect in a case in which InGaAs is used in the additional layer.
Figure 8 is a diagram showing the configuration of a HBT fabricated using the epitaxial substrate having the configuration shown in Figure 1.

### BEST MODE FOR CARRYING OUT THE INVENTION

The present invention will now be described in further detail, with reference to the attached drawings.

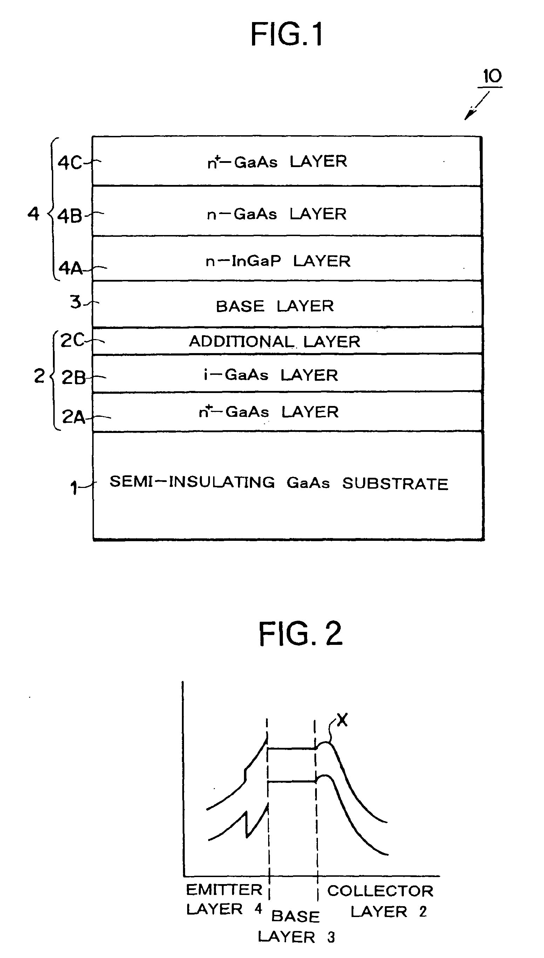

Figure 1 is a diagram showing the layer structure of an embodiment of the semiconductor material according to the present invention. In this embodiment, the semiconductor material shown in Figure 1 is an epitaxial substrate 10 for manufacturing a hetero-junction bipolar transistor (HBT); a collector layer 2, base layer 3 and emitter layer 4 formed in that order on a semi-insulating GaAs substrate 1.

The collector layer 2 is formed as a layer stack comprising, from the semi-insulating GaAs substrate 1 side, an n⁺ -GaAs layer 2A having a carrier concentration in the general order of 10¹⁸ ~ 10¹⁹cm⁻³, an i-GaAs layer 2B, and an additional layer 2C for producing an electron accumulation for promoting band elevation by electrons collected in the collector layer 2. The base layer 3 is formed as a p⁺ -GaAs layer having a carrier concentration in the general order of 10¹⁹ ~ 10²⁰cm⁻³. The emitter layer 4 comprises an n-InGaP layer 4A having a carrier concentration in the general order of 5 x 10¹⁶ ~ 10¹⁸cm⁻³, an n-GaAs layer 4B having a carrier concentration in the general order of 5 x 10¹⁶ ~ 10¹⁸cm⁻³, and an n⁺ -GaAs layer 4C having a carrier concentration in the general order of 10¹⁸ ~ 10¹⁹cm⁻³, formed sequentially in that order on the base layer 3.

The additional layer 2C provided in the collector layer 2 is provided for promoting the accumulation of electrons near the interface between the collector layer 2 and the base layer 3, when the collector current is large or the like, the collector current density rises, and the electron velocity is saturated. The effect that the provision of the additional layer 2C has of accumulating electrons near the interface between the collector layer 2 and the base layer 3 will now be explained with reference to Figure 2.

Figure 2 is a diagram showing the energy band with the horizontal axis being the layer thickness direction. Figure 2 shows the state in which an electron barrier is formed by a conduction band rise X produced by the accumulated electrons in the vicinity of the base layer 3 in the collector layer 2. The additional layer 2C is for controlling the location of this conduction band rise X, and can be formed in the collector layer 2 in the vicinity of the interface between the base layer 3 and the collector layer 2 by suitably determining the location of the additional layer 2C in the collector layer 2 and the thickness thereof.

Since the electron barrier thus formed is produced by electrons collecting near said interface when there is a high collector current density, if the collector current density decreases after the band elevation, the elevation X disappears.

As seen from the above explanation, an additional layer 2C is provided in the collector layer 2, whereby an electron barrier is formed when there is a high collector current density, making it possible to constrain the flow of the collector current and effectively prevent the collector current density becoming abnormally high due to thermal runaway. When the collector current density declines, the electron barrier decreases, so the electron barrier disappears when the collector current density goes below a prescribed level, enabling a good flow of collector current to take place. That is, it is a configuration whereby, only when a state arises in which thermal runaway can arise, such as when the collector current increases or the like, and in response to the increase in the collector current density the flow of collector current is suppressed, making it possible to effectively prevent the semiconductor device from reaching thermal runaway.

In the embodiment shown in Figure 1, the additional layer 2C is configured as a p-GaAs layer having a carrier concentration in the general order of 10¹⁶ ~ 10¹⁸cm⁻³ formed in contact with the base layer 3 as a film having a thickness of approximately 50 nm. If p-GaAs, which is a p-type material, is used for the additional layer 2C, it has the advantage that the conduction band is already elevated, so the required electron barrier can be promptly started when the collector current density reaches a high level.

In the above, the present invention has been explained with respect to an embodiment. However, the present invention is not limited to this embodiment. In order to promote the accumulation of electrons in the collector layer 2, in addition to above configuration in which the collector layer 2 is a p-GaAs layer doped with p-type dopant on the base layer 3 side region of the collector layer 2, a configuration can be used in which in the collector layer 2, an InGaAs layer is provided at a part having a separation from the interface between the collector layer 2 and the base layer 3 that is in the order of 10 ~ 100 nm. Because the conduction band energy of InGaAs is lower than that of GaAs, using an InGaAs layer has the advantage that the electrons collect more readily, so it is easier to elevate the band.

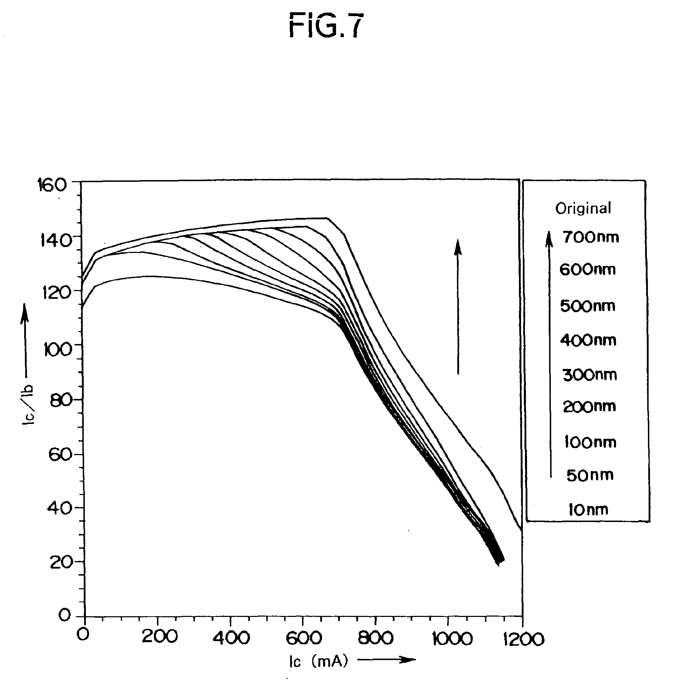

Figure 7 shows the results of a computer simulation using an InGaAs layer. The computation was made assuming a collector film thickness of 800 nm and an InGaAs layer thickness of 15 nm. Under the above conditions, Figure 7 shows the relationship amplification factor (Ic/Ib) and collector current (Ic) when the InGaAs layer was changed from 10 nm ~ 700 nm from the base emitter interface. Here, the ten characteristic curves shown in Figure 7 correspond sequentially to the distance of the InGaAs layer from the base emitter interface, so a comparison with the standard item labeled Original (topmost characteristic curve), it can be understood that even in the case of the low Ic when the InGaAs layer was located 700 nm away from the base collector interface (second characteristic curve from the top), the amplification factor is decreased and an effective suppression of thermal runaway is achieved. As such, it can be understood that the anticipated effect can be obtained, whatever part of the collector layer in the InGaAs layer has the additional layer. Because the magnitude of the effect varies depending on the distance from the interface, it is possible to use the location of the additional layer to adjust the strength of the runaway suppression effect.

It can be expected that the strength of the additional layer effect will vary depending on the thickness of the additional layer. However, the film thickness will never make it impossible to obtain an effect. The film thickness of the additional layer can also be used to adjust the strength of the runaway suppression effect.

In the embodiment shown in Figure 1, the additional layer 2C is provided in the collector layer 2 to actively produce an electron barrier in cases in which the collector current density becomes high. Instead of this, the increase in collector current caused by thermal runaway can be effectively suppressed by configuring a hole barrier in the collector layer 2.

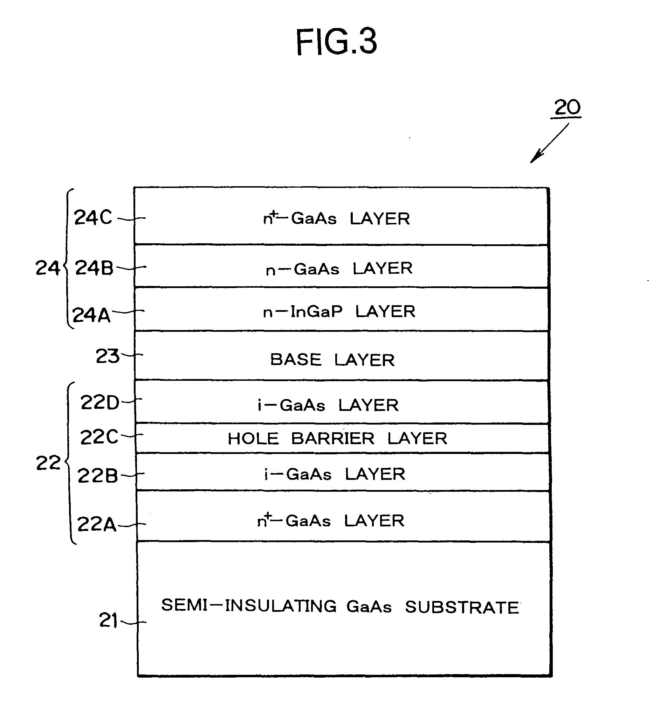

Figure 3 shows another embodiment of the present invention having such a configuration. The semiconductor material shown in Figure 3 is also an epitaxial substrate 20 for manufacturing a hetero-junction bipolar transistor (HBT), and comprises a collector layer 22, base layer 23 and emitter layer 24 formed in that order on a semi-insulating GaAs substrate 21. The collector layer 22 is formed as a layer stack comprising, from the semi-insulating GaAs substrate 21 side, an n⁺ -GaAs layer 22A having a carrier concentration in the general order of 10¹⁸ ~ 10¹⁹cm⁻³, an i-GaAs layer 22B, a hole barrier layer 22C that counters hole diffusion, and an i-GaAs layer 22D. The base layer 23 is formed as a p⁺ -GaAs layer having a carrier concentration in the general order of 10¹⁹ ~ 10²⁰cm⁻³. The emitter layer 24 comprises an n-InGaP layer 24A having a carrier concentration in the general order of 5 x 10¹⁶ ~ 10¹⁸cm⁻³, an n-GaAs layer 24B having a carrier concentration in the general order of 5 x 10¹⁶ ~ 10¹⁸cm⁻³, and an n⁺ -GaAs layer 24C having a carrier concentration in the general order of 10¹⁸ ~ 10¹⁹cm⁻³, formed sequentially in that order on the base layer 3.

The hole barrier layer 22C is provided to prevent an influx of holes from the base layer 23, and in this embodiment is formed as an InGaP layer having a thickness that is in the general order of 1 ~ 100 nm and has a separation from the interface between the base layer 23 and the collector layer 22 that is in the order of 0 ~ 1000 nm, and preferably in the order of 0 ~ 100 nm, whereby it is formed as a barrier layer constituting a hole barrier in the collector layer 22. Also, the i-GaAs layer 22D has a thickness in the general order of 1 ~ 1000 nm, and preferably in the order of 1 ~ 100 nm.

It is preferable for the material of the hole barrier layer 22C to be InGaP having a small conduction band barrier and a large valence band barrier, and in particular, it is most preferable for the In composition to be not less than 0.6. However, AlGaAs, p⁺ -GaAs, or a p⁺ -GaAs having a carrier concentration in the order of 10¹⁹cm⁻³ are other materials that can be used. The hole barrier layer 22C may be provided at any location that is in the order of 100 nm away from the interface of the base layer 23 and collector layer 22. For the same reason as in the case of the above-described additional layer, the location of the hole barrier layer 22C in the collector layer is not limited. In film thickness, in cases where InGaP is used, the film has to be thick enough not to be affected by lattice relaxation and surface defects arising from differences with the lattice constant of GaAs. The object effect of the present invention is obtained with any film thickness value within this range.

In this case, too, material other than the above may be used for the hole barrier layer 22C, if it can be expected to provide the effect of producing a conduction band barrier.

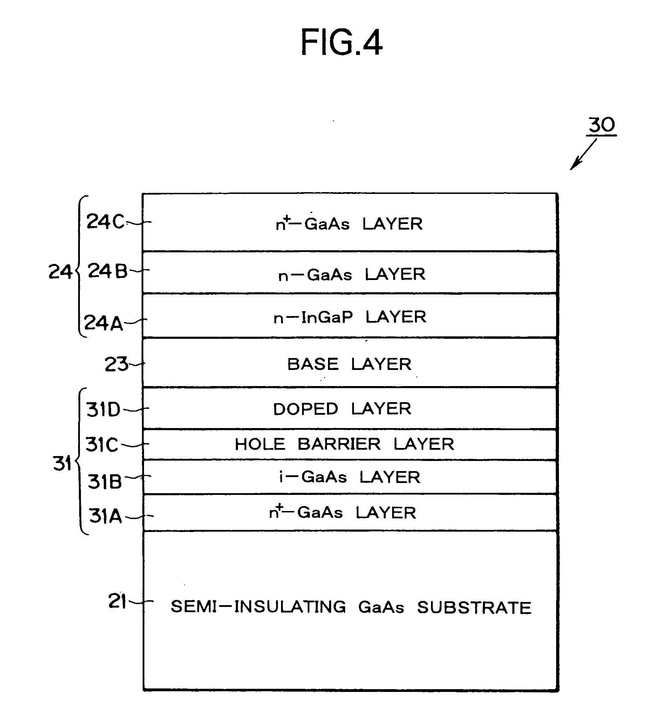

Also, the collector portion sandwiched between the hole barrier layer 22C and the base layer 23 may be a structure doped with p-type dopant, that is, a structure in which the above additional layer is introduced, in which case an even better effect may be obtained. Figure 4 shows a case of this embodiment.

The epitaxial substrate 30 for manufacturing a hetero-junction bipolar transistor (HBT), shown in Figure 4, differs from the embodiment of Figure 3 in that collector layer 31 is formed as a layer stack comprising an n⁺ -GaAs layer 31A, an i-GaAs layer 31 B, hole barrier layer 31C, and doped layer 31D, but other than that has the same configuration as the embodiment of Figure 3. In accordance with this configuration in which the region between the hole barrier layer 31C provided in the collector layer 31 and the base layer 23 is doped with p-type dopant, the doped layer produces quick band elevation, promoting the accumulation of electrons in the collector portion on the outer side of the barrier layer. After the elevation takes place, the barrier layer blocks penetration by holes, whereby the band elevation is maintained.

When there is thus a hole barrier provided by the hole barrier layer 22C in the collector layer 22. band elevation is maintained by the diffused influx of holes. When the hole barrier is introduced into the collector layer 22, it is preferable for the barrier to be inserted into the collector layer 22 from the base side. This is because that effectively adds to the band elevation, further increasing the effect. The hole barrier does not have to be away from the base, and may be in contact with the base. Therefore, if for example InGaP is used as the material of the hole barrier layer 22C, the structure would similar to that of a double hetero-structure HBT. The difference between the above-described configuration according to the present invention and a double hetero-structure is that the collector InGaP is not necessarily in contact with the base.

The suppression of collector current when the collector current is excessive that is the object of the present invention can be obtained using any of the above-described methods, preventing thermal runaway in the transistor. The foregoing description has been made with reference to a HBT on a GaAs substrate with a GaAs base and collector. However, there is no particular limitation to these materials provided the hole barrier effect and the accumulated electron effect can be obtained. The thin films may be fabricated with a MOCVD apparatus, or using MBE or other methods.

### Example 1

The layer structure HBT shown in Figure 1 was manufactured as described below.

A semi-insulating GaAs substrate 1 was introduced into a MOCVD thin-film formation apparatus and n⁺ -GaAs layer 2A (carrier concentration of approximately 1 x 10¹⁸cm⁻³) and i-GaAs layer 2B were formed on the substrate 1 using AsH₃ gas and a metal-organic compound as materials, and as an n-type dopant, Si was introduced in the form of di-silane gas and n-type GaAs formed. Next, C material constituting p-type dopant was introduced in the form of halocarbon, and the additional layer 2C was formed, using the same temperature and growth speed used to grow the i-GaAs layer 2B. Next, base layer 3 was formed on the collector layer 2. The base layer 3 was formed as a p⁺ -GaAs layer (carrier concentration of approximately 4 x 10¹⁹cm⁻³). C material constituting p-type dopant was introduced in the form of halocarbon. Emitter layer 4 was formed, comprising an n-InGaP layer 4A (carrier concentration of approximately 1 x 10¹⁷cm⁻³), an n-GaAs layer 4B (carrier concentration of approximately 1 x 10¹⁷cm⁻³), and an n⁺ -GaAs layer 4C (carrier concentration of approximately 10¹⁸cm⁻³), formed on the base layer 3. The same Si that was used in the forming of the collector layer 2 was used as the n-type dopant. With respect to the InGaP, the P material was supplied in the form of PH₃ gas, replacing the AsH₃.

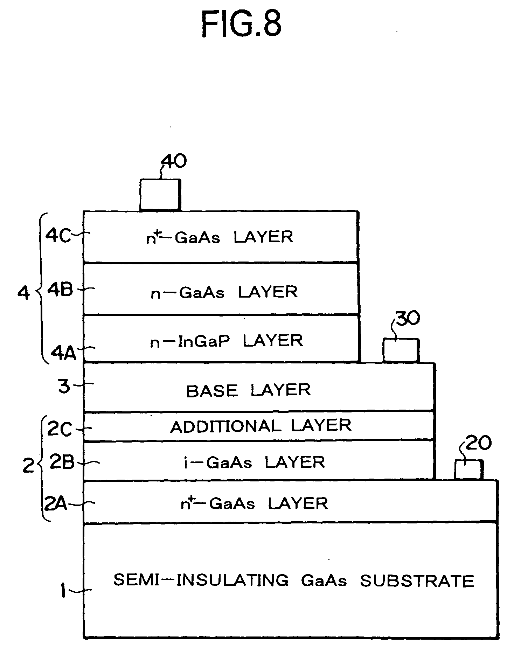

As described above, an HBT was manufactured using an epitaxial substrate for manufacturing an HBT having the layer structure shown in Figure 1. Figure 8 is a diagram of the HBT structure. The HBT structure shown in Figure 8 was manufactured by etching the epitaxial substrate using a resist mask to expose just a portion of each of the n⁺ -GaAs layer 2A and base layer 3, and collector electrode 20 and base electrode 30 were deposited on the respective n⁺ -GaAs layer 2A and base layer 3 in ohmic contact therewith, and an emitter electrode 40 was deposited on an n⁺ -GaAs layer 4C that functions as a sub-emitter, thereby forming a bipolar transistor. A prober was used to measure transistor characteristics.

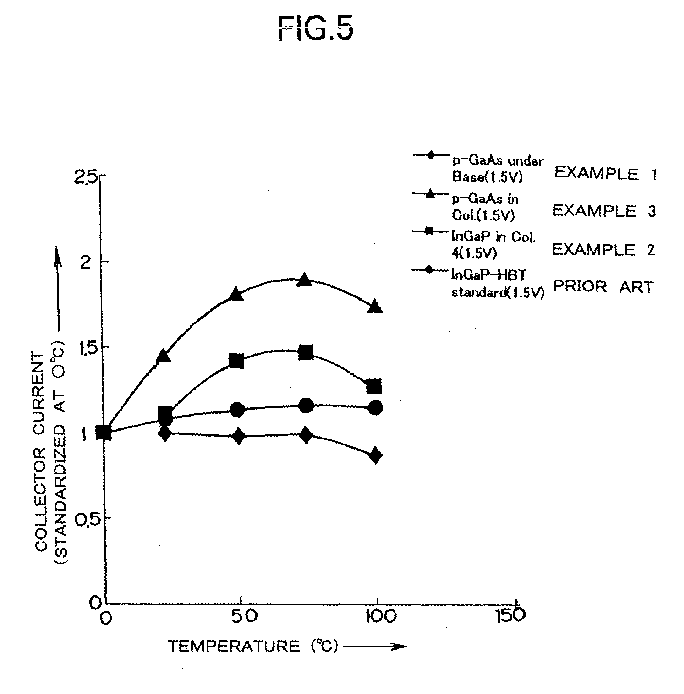

Figure 5 is a graph showing the temperature dependency of the collector current with respect to the above embodiments. Here, the characteristic curve labeled "standard" pertains to a conventional InGaP-HBT (comparative example). The characteristics shown in Figure 5 show the temperature-based changes in collector current at an emitter base voltage of 1.5 V. In the case of each characteristic curve other than the characteristic curve labeled "standard," a decrease in collector current was observed at high temperatures from 75°C to 100°C, confirming the thermal runaway suppression effect. The ratio of the decrease in collector current at high temperatures in the conventional InGaP-HBT was smaller than in any of the embodiment examples, showing there was a danger of thermal runaway.

### Example 2

The layer structure HBT shown in Figure 4 was manufactured as described below.

A semi-insulating GaAs substrate 21 was introduced into a MOCVD thin-film formation apparatus and n⁺ -GaAs layer 31A (carrier concentration of approximately 1 x 10¹⁸cm⁻³) and i-GaAs layer 31B were formed on the semi-insulating GaAs substrate 21 using AsH₃ gas and a metal-organic compound as materials. As an n-type dopant, Si was introduced in the form of di-silane gas and n-type GaAs was formed. Next, approximately 5 nm of InGaP having an In composition of 0.63 for constituting the hole barrier layer 31C was grown at the same temperature used to grow the i-GaAs layer 31B. Next, for the doped layer 31D, C material constituting p-type dopant was introduced in the form of halocarbon, and an approximately 50 nm GaAs layer was grown. Next, base layer 23 is formed on the doped layer 31D. The base layer 23 is compound a p⁺ -GaAs layer (carrier concentration of approximately 4 x 10¹⁹cm⁻³). C material constituting p-type dopant was introduced in the form of halocarbon. The emitter layer 24 comprises an n-InGaP layer 24A (carrier concentration of approximately 1 x 10¹⁷cm⁻³), an n-GaAs layer 24B (carrier concentration of approximately 1 x 10¹⁷cm⁻³) and an n⁺ -GaAs layer 24C (carrier concentration of approximately 1 x 10¹⁸cm⁻³), formed on the base layer 23. The same Si that was used in the forming of the collector layer 2 was used as the n-type dopant. With respect to the InGaP, the P material was supplied in the form of PH₃ gas, replacing the AsH₃.

As described above, an HBT was manufactured using an epitaxial substrate for manufacturing an HBT having the layer structure shown in Figure 4. This HBT was manufactured using the same procedure described in the case of Example 1 with reference to Figure 8. This manufacturing procedure and the electrode attachment structure are basically the same as in the case of the HBT of Figure 8, so a detailed explanation thereof is omitted here.

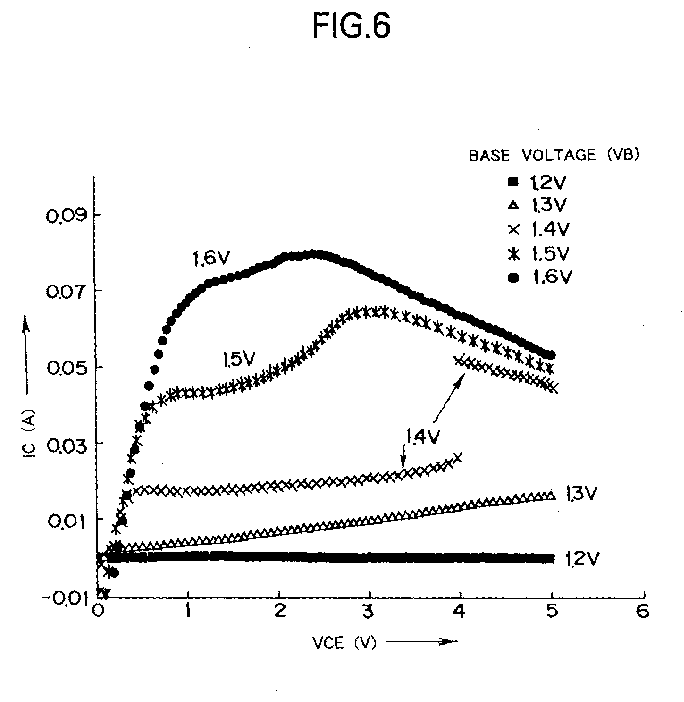

Figure 6 shows the results, in Example 2, of measuring the relationship between voltage VCE, between collector and emitter, and collector current IC, at 23°C, using base voltage VB as a parameter. From the measurement results shown in Figure 6, it can be understood that up to VB = 1.2 V, transistors in which runaway did not arise operated normally. At VB = 1.3 V, thermal runaway started and the collector current gradually increased owing to positive feedback of the collector current. The characteristic operation here could be observed from VB = 1.4 V and above. At VB = 1.4 V, at VCE = 4 V, there was a rapid increase in the collector current; that is, thermal runaway was observed. However, the collector current was promptly suppressed, stopping thermal runaway. At and over VB = 1.5 V, thermal runaway had already started, at or below VCE = 1 V, and at VCE = 2 ~ 3 V, it was confirmed that runaway was slowly suppressed.

In accordance with this invention, by employing a band structure in the collector layer of a bipolar transistor that can block the movement of electrons that causes thermal runaway, changes in characteristics due to heat generated by current during bipolar transistor operation are controlled without using ballast resistances and other such external devices, making it possible to realize a bipolar transistor that operates stably with respect to temperature changes, so no problems arise such as decreases in high-frequency gain and degradation of device characteristics, and there are also no problems of increased device size or throughput being reduced by an increase in the number of device process steps.

### Example 3

The layer structure HBT shown in Figure 3 was manufactured as described below.

A semi-insulating GaAs substrate 21 was introduced into a MOCVD thin-film formation apparatus and n⁺ -GaAs layer 22A (carrier concentration of approximately 1 x 10¹⁵cm⁻³) and i-GaAs layer 22B were formed on the semi-insulating GaAs substrate 21 using AsH₃ gas and a metal-organic compound as materials. As an n-type dopant, Si was introduced in the form of di-silane gas and n-type GaAs was formed. Next, approximately 100 Å of p-GaAs layer constituting hole barrier layer 22C was grown at the same temperature used to grow the i-GaAs layer 22B. For the p-GaAs layer, C material constituting p-type dopant was introduced in the form of hydrogen halide. In this example, the C concentration of the barrier layer was set at approximately 2 x 10¹⁹cm⁻³. Approximately 500 Å of an i-GaAs layer 22D was grown on the barrier layer, using the same conditions used for the i-GaAs layer 22B. Next, base layer 23 was formed on i-GaAs layer 22D. The base layer 23 comprises a p⁺ -GaAs layer. C material constituting p-type dopant was introduced in the form of hydrogen halide, as in the case of the hole barrier layer 22C. However, the carrier concentration was set at 4 x 10¹⁹cm⁻³. The emitter layer 24 comprising an n-InGaP layer 24A (carrier concentration of approximately 1 x 10¹⁷cm⁻³), an n-GaAs layer 24B and an n⁺ -GaAs layer 24C was formed on the base layer 23. As in the case of the collector layer 22, Si was used as the n-type dopant. With respect to the InGaP, the P material was supplied in the form of PH₃, replacing the AsH₃.

As described above, an HBT was manufactured using an epitaxial substrate for manufacturing an HBT having the layer structure shown in Figure 3. This HBT was manufactured using the same procedure described in the case of Example 1 with reference to Figure 8. Figure 5 shows the temperature variations in the collector current at a base bias of 1.6 V, in the HBT thus manufactured. At first the collector current increases as the temperature rises but, as in Example 1, the collector current decreases from about when 70°C is exceeded. By means of this effect, thermal runaway can be effectively suppressed.

### INDUSTRIAL APPLICABILITY

As in the above, the semiconductor material having a bipolar transistor structure and semiconductor device using same according to the present invention, have a thermal runaway suppression structure, and is therefore useful for manufacturing various electronic devices without the occurrence of problems such as increased device size or decrease in throughput or the like.

## Claims

1. A semiconductor material comprising a bipolar transistor structure having a collector layer, a base layer and an emitter layer, **characterized by** the provision of a hole barrier layer for preventing diffusion of holes having the effect of lowering band elevation by electrons accumulated in the collector layer when the collector current density increases, maintaining band elevation.

2. A semiconductor material according to claim 1, wherein the additional layer is an InGaAs layer.

3. A semiconductor material according to claim 1, wherein the additional layer is a layer doped with up to 1 x 10¹⁸cm⁻² p-type dopant.

4. A semiconductor material comprising a bipolar transistor structure having a collector layer, a base layer and an emitter layer, **characterized by** the provision of a hole barrier layer in the collector layer for maintaining band elevation by electrons accumulated in the collector layer when the collector current density increases by preventing diffusion of holes having the effect of lowering band elevation.

5. A semiconductor material according to claim 4, having a layer doped by p-type dopant between the hole barrier layer and the base layer.

6. A semiconductor material according to claim 4 or 5, manufactured using a chemical compound semiconductor substrate, wherein the material of the collector layer is GaAs or InGaAs, and the material of the hole barrier layer is any from among InGaP, InGaAsP, InGaAs, p⁺ -GaAs, GaAs and p⁺ -InGaAs.

7. A semiconductor material according to claim 4, wherein the material of the hole barrier layer is InGaP having an In composition of not less than 0.6.

8. A semiconductor material according to claim 1, wherein a hole barrier layer for preventing diffusion of holes is provided between the additional layer and the base layer.

9. A semiconductor device manufactured using semiconductor material according to any of claims 1 to 8.
